# FASCICULE DE BREVET EUROPEEN

(11) **EP 1 633 480 B1**
(45) Date de publication et mention de la délivrance du brevet: **06.04.2011**
(21) Numéro de dépôt: 04767836.2
(22) Date de dépôt: 14.06.2004
(51) Int. Cl.: B01L 3/00

(54) **PROCEDE DE COLLAGE DE SUBSTRATS MICRO-STRUCTURES**
VERFAHREN ZUR VERBINDUNG VON MIKROSTRUKTURIERTEN SUBSTRATEN
METHOD OF BONDING MICROSTRUCTURED SUBSTRATES

(30) Priorité: 16.06.2003 FR 0350218
(43) Date de publication de la demande: 15.03.2006
(73) Titulaire: Commissariat à l'Énergie Atomique et aux Énergies Alternatives, 75015 Paris (FR); BIOMERIEUX SA, 69280 Marcy L'Etoile (FR)
(72) Inventeur: CHARTIER, Isabelle, F-38000 Grenoble (FR); BORY, Cécile, F-38120 Le Fontanil (FR); POUTEAU, Patrick, F-38240 Meylan (FR)
(74) Mandataire: Poulin, Gérard
(86) Numéro de dépôt international: PCT/FR2004/050274
(87) Numéro de publication internationale: WO 2004/112961

(56) Documents cités:
- WO-A-99/18422
- JP-A- 2000 246 092
- AWATANI Y ET AL: "Damage free dicing method for MEMS devices" 2002, IEEE/LEOS INTERNATIONAL CONFERENCE ON OPTICAL MEMS (CAT. NO.02EX610), LUGANO, SWITZERLAND, 20-23 AUG. 2002 , PISCATAWAY, NJ, USA, IEEE, USA, PAGE(S) 137 - 138 , XP010602742 ISBN: 0-7803-7595-5 le document en entier
- SASAKI S ET AL: "Screen printed adhesive technologies for all-silicon optical packaging" 1996, 46TH ELECTRONIC COMPONENTS AND TECHNOLOGY CONFERENCE, PROCEEDINGS, ORLANDO, FL, USA 28-31 MAY 1996, IEEE, US, PAGE(S) 1289-1293 , NEW YORK, NY, USA , XP010167189 ISBN: 0-7803-3286-5 le document en entier
- HUANG T ET AL: "MICROFABRICATION OF MICROFLUIDIC CARTRIDGE FOR ISOELECTRIC FOCUSING BY SCREEN PRINTING" SENSORS AND MATERIALS, SCIENTIFIC PUBLISHING DIVISION OF MYU, TOKYO, JP, vol. 14, no. 3, 2002, pages 141-149, XP009023885 ISSN: 0914-4935

## Description

### DOMAINE TECHNIQUE

La présente invention concerne un procédé de collage de substrats micro-structurés.

Elle s'applique notamment au domaine des micro-systèmes, qui nécessitent l'assemblage de substrats micro-structurés, comprenant des cavités ou des motifs de dimensions très faibles, par exemple inférieures à 50 micromètres.

L'invention s'applique en particulier à la fabrication de micro-structures, telles que les laboratoires sur puces (« labs-on-chips ») et les biopuces (« biochips »), destinées à être utilisées dans le domaine de la biologie et comportant des surfaces pourvues de sondes biologiques, par exemple des sondes à ADN ou à protéines, qui sont prévues pour réagir avec des échantillons devant être analysés.

L'invention s'applique aussi à la fabrication de structures micro-fluidiques et plus particulièrement, dans le domaine de la biologie, à la fabrication de laboratoires sur puces, mais aussi à la fabrication des micropiles à combustible des échangeurs thermiques, des MEMS (Mechanical Electrical Micro Systems) et des MOEMS (Mechanical Opto-Electrical Micro Systems).

### ETAT DE LA TECHNIQUE ANTERIEURE

L'utilisation de composants micro-fluidiques tels que les laboratoires sur puces, pour des applications biologiques, permet d'intégrer des moyens de mise en oeuvre de l'ensemble ou de parties des étapes d'un protocole biologique dans un même composant.

Ainsi peut-on par exemple intégrer dans ce dernier des moyens de préparation d'un échantillon et des moyens d'obtention de réactions biologiques comme l'hybridation, la séparation et la détection, à la différence des biopuces qui sont des composants planaires (« planar »), comportant des sondes biologiques sur lesquelles on dépose un échantillon préalablement préparé.

La fabrication de composants micro-fluidiques comprend en général une étape de formation de cavités micro-fluidiques (canaux, chambres ou réservoirs) dans un substrat, suivie d'une étape d'assemblage qui permet la fermeture étanche de ces cavités par un autre substrat ou capot.

La largeur des cavité micro-fluidiques va typiquement de 10µm jusqu'à plusieurs millimètres tandis que leur profondeur varie typiquement entre 10µm et 500µm.

L'étape de formation de ces cavités peut mettre en oeuvre différentes techniques suivant la nature du substrat dans lequel on les forme. On peut par exemple utiliser :
- une gravure (« etching ») chimique ou ionique avec le silicium,
- une gravure chimique ou un usinage par ultrasons ou par laser avec le verre, et
- une réplication par injection, un matriçage à chaud ou un coulage à partir de moules comportant le motif cherché, un usinage mécanique, une ablation par laser ou une croissance par laser (stéréopholithographie) avec les polymères.

On peut aussi utiliser la lithographie de résines positives ou négatives ou de films photosensibles laminés, sur un substrat en verre, en silicium ou en polymère.

De même, différentes techniques d'assemblage existent et sont utilisées suivant les matériaux employés.

La difficulté de l'assemblage des structures micro-fluidiques réside dans la petite taille des motifs qu'elles comportent : les espaces qui sont libres (et dont la taille va typiquement de 10µm à 1mm) doivent le rester ; en particulier, la colle ne doit pas y pénétrer.

De plus, le procédé de fermeture des cavités micro-fluidiques ne doit ni détruire ces cavités ni modifier leur géométrie.

D'autre part, il est important que toutes les surfaces destinées à être en contact avec le substrat de fermeture soient rendues solidaires de ce dernier lors de l'étape d'assemblage, afin d'éviter les volumes morts qui nuisent à la circulation prévue pour les fluides et sont susceptibles de piéger des bulles ou des espèces chimiques.

Au sujet des diverses techniques que l'on peut utiliser pour la fermeture de composants micro-fluidiques, suivant les matériaux devant être assemblés, on pourra se reporter au document suivant :
[1] US 5 842 787A (Kopf-Sill et al.).

En particulier, pour l'assemblage de substrats en verre ou en silicium, les techniques connues font appel à des scellements à de très hautes températures, qui sont incompatibles avec la formation de sondes biologiques sur ces substrats, avant l'assemblage de ceux-ci.

En ce qui concerne l'assemblage de substrats polymères, on pourra se reporter au document suivant :
[2] WO 99/56954A (Caliper Technologies Corp.).

Ce document divulgue des techniques de soudure thermique. Cependant, avec ces techniques, on ne peut utiliser qu'un nombre limité de matériaux capables de se souder entre eux. De plus, les assemblages obtenus résistent mal aux contraintes thermiques et ces techniques sont difficilement compatibles avec la mise en place de sondes biologiques sur les surfaces que l'on veut assembler.

D'autres techniques connues utilisent des seringues pour déposer automatiquement la colle. Cependant, ces techniques ne conviennent pas à l'assemblage de structures comportant des motifs très fins, de l'ordre de 50µm à 100µm ou moins.

Il faut en effet déposer la colle jusqu'au bord des motifs pour éviter tout volume mort et l'emprisonnement de bulles d'air, tout en s'assurant que la colle ne coule pas dans les cavités prévues sur ces structures et risque de les boucher ou d'en changer le volume.

Les techniques de collage couramment employées ne sont pas compatibles avec les espèces biologiques déposées ou alors pas assez précises pour les structures micro-fluidiques.

Lorsqu'un composant micro-fluidique doit être pourvu de sondes biologiques, on préfère donc former celles-ci en utilisant une solution, une fois le composant assemblé. On forme alors les sondes sur l'ensemble des surfaces du composant, ce qui peut être, dans certains cas, un inconvénient pour la détection optique.

De plus, une telle technique ne permet pas de greffer des sondes multiples dans un même composants ni de localiser géométriquement les zones pourvues de sondes, alors que cela est possible dans le cas de composants planaires ouverts, tels que les biopuces.

On connaît également des automates qui permettent la formation de matrices de points pourvus de sondes biologiques différentes mais ces automates projettent des gouttes et ne peuvent donc être utilisés que sur des surfaces libres. En conséquence, ils ne sont plus utilisables après la fermeture du composant micro-fluidique.

On connaît en outre des techniques d'enduction par contact, telles que l'enduction au moyen d'un rouleau et la tampographie, qui permettent de transférer un film cohérent sur un substrat.

A ce sujet, on se reportera au document suivant :
[3] WO 00/77509A (Merck Patent GmbH et al.)

Cependant, la résolution de ces techniques d'enduction connues est trop faible, en particulier pour l'encollage de substrats microstructurés, destinés à la fabrication de composants micro-fluidiques tels que, par exemple, les laboratoires sur puces.

Plus précisément, l'utilisation de telles techniques ne permet pas à la surface d'une cavité de très petites dimensions de séparer le film cohérent- c'est-à-dire continu- de colle de son moyen de transfert (rouleau ou tampon) de sorte que cette cavité se trouve recouverte de ce film de colle.

### EXPOSÉ DE L'INVENTION

La présente invention a pour but de remédier aux inconvénients précédents. Y. Awatani et al., IEEE/LEOS Int. conf. on opt. MEMS, Lugano, Suisse, 20-23 août 2002, pp. 137-138, décrit un procédé de découpe, sans dommage, pour des dispositifs MEMS. S. Sasaki et al., 46th Electr. comp. and techn. conf., proc., Orlando FI, USA, 28-31 mai 1996, pp. 1289-1293, décrit des techniques de collage utilisant la sérigraphie, pour le conditionnement optique tout silicium. JP 2000246092A décrit un procédé de fabrication de dispositifs microchimiques.

De façon précise, l'invention a pour objet un procédé d'encollage d'au moins un substrat micro-structuré comportant des zones planes supérieures coplanaires et des creux entre ces dernières, au moyen d'une colle apte à adhérer à ces zones planes supérieures coplanaires, dans lequel :
- on met en place une grille sans masque au dessus du substrat,
- on enduit cette grille de la colle, au moyen d'un outil qui, par appui sur la grille, met localement cette grille en contact avec les zones planes supérieures coplanaires, de manière à déposer un film de gouttelettes de colle sur ces zones planes supérieures coplanaires, et
- on retire la grille,
procédé dans lequel on effectue un traitement des zones planes supérieures coplanaires avant d'y déposer le film de gouttelettes de colle, ce traitement étant prévu pour adapter la mouillabilité de ces zones à la colle.

Ainsi, en vue d'une définition plus précise du dépôt de colle, on propose de déposer, à travers la grille et à l'aide de l'outil, un film de gouttelettes de colle qui se rejoignent pour constituer un film cohérent de colle (c'est-à-dire un film continu de colle) sur les surfaces à coller.

La résolution est ainsi améliorée car elle est, en quelque sorte, définie par la taille des gouttelettes.

On adapte la taille des trous de la grille, le pas (« pitch ») et la hauteur de cette grille et la mouillabilité des surfaces de la grille et des zones planes du substrat de façon à obtenir le meilleur résultat possible.

L'outil utilisé dans l'invention est de préférence une racle.

Selon un mode de réalisation particulier de l'invention, ce traitement est prévu pour contrôler l'étalement des gouttelettes de colle sur les zones planes supérieures coplanaires.

L'invention concerne aussi un procédé de collage dans lequel, après avoir déposé la colle sur les zones planes supérieures coplanaires conformément à l'invention, on ferme le substrat micro-structuré par un substrat de fermeture que l'on fixe aux zones planes supérieures coplanaires par l'intermédiaire de la colle déposée sur celles-ci.

Les creux du substrat micro-structuré peuvent comporter des zones pourvues de sondes biologiques.

Le substrat de fermeture peut comporter des zones pourvues de sondes biologiques, ces zones étant aptes à se trouver en regard de creux du substrat micro-structuré après avoir fermé ce substrat micro-structuré.

La matière, que l'on peut introduire tant dans le substrat micro-structuré que dans le substrat de fermeture, peut être biologique ou non, sous forme sèche ou humide.

En outre, le substrat de fermeture peut comporter des perçages prévus pour l'introduction d'un fluide dans les creux du substrat micro-structuré.

Selon un premier mode de mise en oeuvre particulier du procédé objet de l'invention, on fabrique au préalable, de façon collective, un ensemble de substrats micro-structurés sur un même substrat, les zones planes supérieures de l'ensemble des substrats micro-structurés étant coplanaires, on dépose un film de gouttelettes de colle sur l'ensemble de ces zones planes supérieures de façon collective, on ferme l'ensemble des substrats micro-structurés par un même substrat de fermeture et l'on sépare les uns des autres les substrats micro-structurés ainsi fermés.

Selon un deuxième mode de mise en oeuvre particulier, on fabrique au préalable, de façon collective, un ensemble de substrats micro-structurés sur un même substrat, les zones planes supérieures de l'ensemble des substrats micro-structurés étant coplanaires, et l'on fabrique aussi au préalable, de façon collective, un ensemble de substrats de fermeture sur un autre substrat, on sépare les uns et des autres les substrats micro-structurés et les substrats de fermeture et l'on ferme les substrats micro-structurés par les substrats de fermeture, après avoir déposé un film de gouttelettes de colle sur les zones planes supérieures coplanaires de chaque substrat micro-structuré.

Chaque substrat peut être fait d'un matériau choisi parmi le verre, le silicium et les polymères.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figures 1A à 1C illustrent schématiquement des étapes d'un mode de mise en oeuvre particulier du procédé objet de l'invention,
- les figures 2A et 2B illustrent schématiquement la formation d'un réseau de micro-gouttelettes de colle puis la formation d'un film de colle cohérent conformément à l'invention, et
- la figure 3 illustre schématiquement la fermeture d'un substrat micro-structuré par un capot conformément à l'invention.

### EXPOSÉ DÉTAILLÉ DE MODES DE RÉALISATION PARTICULIERS

Etant donné un composant micro-fluidique comprenant des structures micro-usinées, ou micro-cavités, de très faibles dimensions (environ 5µm à 50µm), l'invention permet de fermer un tel composant sans en changer la forme, sans créer aucun volume mort et sans boucher les micro-cavités, en ayant éventuellement formé, au préalable, une matrice de sondes biologiques sur le substrat destiné à fermer le composant ou dans des creux du composant (substrat micro-structuré).

Pour ce faire, conformément à l'invention, on utilise une technique de sérigraphie pour enduire de colle le substrat comprenant les micro-cavités.

Contrairement à son utilisation habituelle, limitée à la définition de motifs de dimensions importantes (au moins 300µm), la sérigraphie est mise en oeuvre sans masque dans l'invention et, grâce à un contrôle de l'énergie de surface du substrat, permet de réaliser une enduction parfaitement conforme aux micro-motifs que comporte le substrat, sans boucher ces micros-motifs, même les plus fins d'entre eux.

En effet, contrairement à d'autre techniques d'enduction par contact, comme par exemple la tampographie ou l'enduction par rouleau, qui permettent de transférer un film cohérent sur un substrat (voir le document [3] mentionné plus haut), l'invention permet d'abord d'obtenir, grâce à la sérigraphie, un réseau (« array ») de micro-gouttes qui est déposé, par contact, sur les parties supérieures coplanaires du substrat.

Ensuite, à condition que la mouillabilité de la colle sur le substrat soit bien adaptée, ces micro-gouttes se rejoignent - elles sont « tirées » par l'énergie de la surface du substrat - jusqu'à former un film cohérent (c'est-à-dire continu), parfaitement conforme aux micro-structures du substrat.

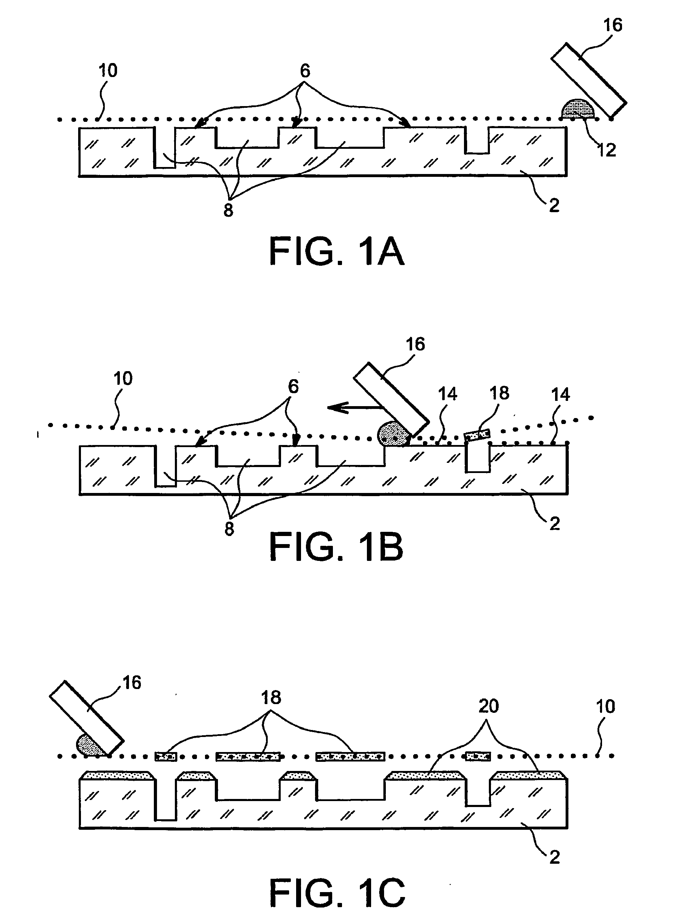

Un exemple du procédé objet de l'invention est schématiquement illustré par les figures 1A à 1C et permet d'enduire de colle un substrat micro-structuré 2 par sérigraphie, en deux phases, à savoir (a) le dépôt d'un réseau de micro-gouttes de colle et (b) la formation d'un film de colle cohérent, conforme aux structurations du substrat.

La figure 1A montre le substrat micro-structuré 2, comportant des zones planes supérieures copolaires 6 et des creux 8 entre ces dernières. Ces creux constituent des micro-cavités destinées à recevoir un fluide.

On met en place une grille 10 (sans masque) au-dessus du substrat et, à une extrémité de cette grille, on place un volume 12 d'une colle apte à adhérer aux zones 6.

Comme le montre la figure 1B, on dépose ensuite un réseau 14 de micro-gouttes de colle sur les zones 6. Pour ce faire, on enduit la grille 10 de colle au moyen d'un outil, tel qu'une racle 16, que l'on déplace sur la grille et qui, en appuyant sur cette dernière, la met localement en contact avec les zones 6, de manière à former le réseau 14. La grille doit donc présenter une certaine souplesse, à calculer au préalable.

Sur la grille, que l'on peut alors retirer, il subsiste de la colle, dans les zones 18 qui se trouvent au dessus des micro-cavités 8.

La figure 1C montre la formation d'un film de colle continu 20, conforme aux zones 6, ou reliefs, par étalement des micro-gouttes du réseau 14 que l'on a déposé.

L'avantage d'une enduction en deux phases conformément à l'invention est de permettre la fermeture de micro-cavités de très petites dimensions dont la surface, par exemple dans le cas de la tampographie ou de l'enduction par rouleau, n'aurait pas été capable de séparer le film de colle cohérent transféré et aurait donc été recouverte par ce film de colle.

En effet, le transfert est réalisé du support de transfert (par exemple un tampon ou un rouleau) au substrat si l'adhérence du film de colle sur ce substrat est supérieure à son adhérence sur le support de transfert.

Considérons alors une cavité formée à la surface du substrat et ayant une aire déterminée, comptée parallèlement à cette surface.

Dans le cas du transfert d'un film de colle cohérent, l'adhérence, ou force d'adhésion, de ce film sur le support de transfert, cette force correspondant à l'aire déterminée, doit être supérieure à la tension superficielle du film de colle pour couper ce film au bord de la cavité.

Si cette condition est remplie tant que l'aire correspondant à la cavité reste suffisamment grande, elle ne l'est plus lorsque cette aire devient très petite. L e film ne peut alors être rompu ; il reste cohérent et recouvre la cavité.

En revanche, en ce qui concerne l'invention, dans le cas du transfert d'un réseau de micro-gouttes, l'adhérence sur le support de transfert, à savoir la grille, n'est liée qu'à la surface des micro-gouttes qui se déposeront seulement sur les surfaces du substrat en contact avec la grille, ce qui permet de ne pas recouvrir des cavités de très petites dimensions.

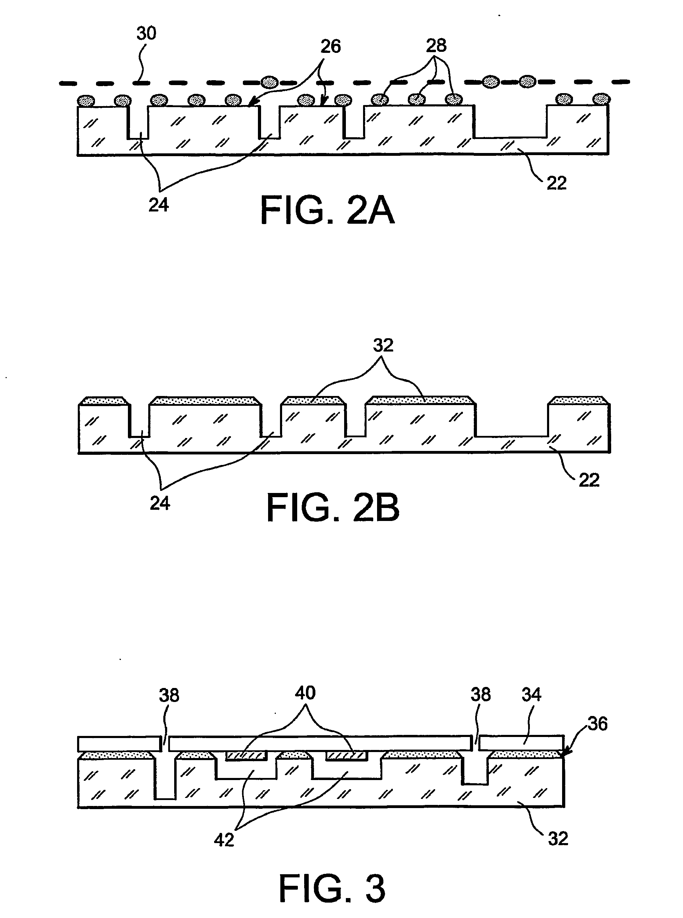

Ceci est schématiquement illustré par la figure 2A où l'on voit un substrat micro-structuré 22, comportant des cavité 24 de très faibles dimensions.

Sur les surfaces supérieures 26 du substrat, on transfère un réseau de micro-gouttes de colle 28 que l'on dépose par sérigraphie, au moyen d'une grille 30. La colle ne pénètre pas dans les cavités 24.

La taille des micro-gouttes 28 est proche de la taille des plus petites cavités.

Les micro-gouttes se regroupent ensuite, pour former des films continus 32 de colle à la surface du substrat (figure 2B).

L'épaisseur du film de colle formé est définie par les paramètres suivants :
- le volume des micro-gouttes et la densité du réseau de micro-gouttes déposé, qui sont définis par le choix de la grille de sérigraphie,
- l'énergie et la tension de surface du support enduit, la viscosité de la colle, et
- les paramètres de raclage, à savoir le matériau et la dureté de la racle, la vitesse et la force de raclage, et la distance entre la grille et le substrat.

La dimension des micro-gouttes est adaptée au plus petit motif creux (cavité) présent sur le substrat.

Suivant les besoins des utilisateurs, l'épaisseur du film de colle peut être choisie entre 0,1µm et 100µm.

De préférence, lorsque l'un au moins de s deux substrats comporte des cavités dont la taille est inférieure à 20µm, l'épaisseur du film est comprise entre 0,5µm et 2µm.

Des avantages de l'invention sont les suivantes :
- Cette invention permet l'assemblage de substrats structuré s, comportant des cavités de très petites dimensions, de moins de 50µm de large, sans boucher ni recouvrir d'un film de colle ces cavités.
- L'invention est une technique de collage qui est compatible avec la formation de sondes biologiques multiples, de manière localisée, sur le ou les substrats devant être assemblés, avant cet assemblage.
- La mise en oeuvre de l'invention est compatible avec un grand nombre de colles ayant des caractéristiques fonctionnelles variées, adaptées à l'utilisation, par exemple la tenue en température et la charge introduite dans les colles. On peut par exemple utiliser des colles à base de silicones, acryliques, époxydes, cationiques, polymérisables par chauffage, par un rayonnement ultraviolet ou par l'humidité, à un ou deux composants.
- L'invention permet la fermeture collective de puces (« chips ») sur une plaquette (« wafer ») semiconductrice et constitue une technique adaptable à toute taille de substrat (des écrans de sérigraphie supérieurs à 1m² étant disponibles), avec une grande homogénéité
- L'invention permet aussi la fermeture individuelle de composants.

Les cavités micro-fluidiques peuvent être formées par gravure dans un substrat en silicium ou en verre, ou par matriçage à chaud, injection, gravure par plasma ou gravure par laser à partir d'un matériau polymère, ou au moyen d'une couche de résine photosensible.

La largeur des canaux de ces cavités micro-fluidiques va typiquement de 10µm à 100µm, tandis que la largeur des chambres et des réservoirs de ces cavités va typiquement de 2mm à 10µm, et la profondeur de gravure varie entre 40µm et 500µm.

La préparation de la surface du substrat est effectué par exemple au moyen d'un plasma, d'un rayonnement ultraviolet, d'ozone, d'un traitement HMDS, ou d'une silanisation afin d'adapter la mouillabilité de la surface à la colle choisie. Un traitement hydrophobe ou hydrophile peut être choisi pour contrôler l'étalement des micro-gouttes qui auront été déposées.

Le second substrat ou capot, qui est destiné à la fermeture des cavités, est par exemple une plaque de silice, de polymère ou de silicium.

L'enduction de colle est faite par sérigraphie en utilisant par exemple un écran de toile en polyester, en polyamide ou en acier. De préférence, on utilise un écran en polyester, tout type de colle, y compris les polymères fluides, étant alors utilisable, qu'elle soit à un ou deux composants et qu'elle soit réticulable par un rayonnement ultraviolet, par chauffage ou par l'air.

La colle (au sens large, en incluant les polymères fluides) est adaptée aux matériaux des substrats à assembler. Ces substrats peuvent être faits de matériaux différents (collage hybride), tels que le verre, le silicium, les polymères et les métaux.

La colle peut être choisie pour adapter les caractéristiques du joint que l'on veut former (entre le substrat micro-structuré et le capot) aux contraintes d'utilisation du composant micro-fluidique que l'on fabrique : par exemple, on peut vouloir obtenir un joint souple ou rigide, électriquement ou thermiquement conducteur ou isolant, ayant une épaisseur définie et contrôlée (utilisation d'une colle comprenant des espaceurs), et ayant des propriétés optiques définies (par exemple transparence ou fluorescence), et ayant une résistance thermique ou chimique.

Les colles utilisées doivent répondre à différents critères de choix, principalement la compatibilité biologique avec les sondes éventuellement déposées sur le capot et avec les échantillons liquides, le mode de polymérisation qui ne doit pas détruire les sondes biologiques (température inférieure à 120°C ou insolation par un rayonnement ultraviolet).

On peut utiliser une large gamme de viscosités pour la colle, allant par exemple de 3000mPa.s (état très liquide) à 50000mPa.s (état pâteux).

Conformément à l'invention, l'enduction se fait sur le substrat structuré et l'écran de sérigraphie ne comprend pas de motifs pour définir les zones de dépôt de la colle (contrairement à un pochoir).

La colle ne se dépose alors que sur les structures coplanaires supérieures qui entrent en contact avec cette colle lors du raclage. Ainsi, la colle n'est pas déposée au fond des cavités micro-fluidiques (canaux, chambres ou réservoirs).

Dans un exemple, le substrat est placé, sans alignement, sous l'écran de sérigraphie, à une distance comprise entre 0,5mm et 2mm ; un boudin de colle est déposé sur l'écran, la longueur de ce boudin étant égale ou légèrement supérieure à la largeur du substrat ; la colle est alors écrasée à l'aide d'une racle en gomme dure, en réalisant un déplacement linéaire sur toute la longueur du substrat.

L'épaisseur du film de colle que l'on dépose sur le substrat est définie par le type d'écran de sérigraphie (matière, nombre de fils/cm, diamètre des fils et taille des mailles), la nature de la colle utilisée (viscosité, tension de surface) et la matière du substrat (silicium ou polymère par exemple).

Dans certains cas, on peut vouloir définir un pochoir grossier, dont les motifs ont des dimensions très supérieures à celles des structures micro-fluidiques, pour éviter le dépôt de colle non utile sur des surfaces importantes (par exemple pour permettre le détourage du substrat ou la définition de chemins de découpe). Ce pochoir grossier ne rajoute aucune étape d'alignement précise.

Le capot (substrat de fermeture) est ensuite déposé sur le substrat structuré encollé en utilisant soit un alignement mécanique (à l'aide d'une pièce mécanique qui guide les deux substrats), soit un alignement optique (à l'aide d'une machine de positionnement micro-électronique de type « wafer bonding » ou « mask aligner » (aligneur de masque)) afin de positionner les zones pourvues de sondes biologiques en regard des chambres micro-fluidiques.

Une pression est alors appliquée entre les deux substrats ainsi alignés. De préférence, on réalise un vide léger entre ces deux substrats afin d'éliminer d'éventuelles bulles d'air qui nuiraient à l'étanchéité du joint de colle.

La colle est ensuite polymérisée suivant un procédé adapté à cette colle. On peut utiliser une polymérisation thermique en étuve et/ou une insolation par un rayonnement ultraviolet.

La figure 3 est une vue schématique d'un substrat micro-structuré 32 qui est fermé par un capot 34. Ce capot est fixé au substrat par un film de colle 36 que l'on a formé sur le substrat conformément à l'invention.

Le capot 34 peut comprendre, ou non, des ouvertures 38 pour l'injection de fluides.

On voit en outre que le capot est pourvu d'un réseau de sondes biologiques 40 en regard de cavités 42 du substrat 32.

La présente invention permet la fermeture collective de puces fluidiques. Ces puces peuvent être formées collectivement sur un substrat en silicium, en verre ou en polymère et comporter des zones formant des réservoirs ou des canaux que l'on obtient par exemple par une étape de photolithographie d'une résine épaisse, par exemple la résine commercialisée sous la référence SU8.

On dépose la colle conformément à l'invention par une sérigraphie sans masque, sur les zones prévues à cet effet sur l'ensemble des puces. On ferme ensuite cet ensemble de puces de façon collective par un capot en matière plastique, en verre ou en silicium que l'on pose sur les zones pourvues de colle.

L'alignement entre le substrat et le capot peut être fait de façon mécanique, au moyen d'une pièce mécanique de pré-positionnement, ou de façon optique, au moyen d'une machine de positionnement micro-électronique du genre de celles qui servent à fixer deux plaquettes de silicium l'une à l'autre.

Après positionnement du capot sur le substrat pourvu de la colle, le capot est plaqué sur ce substrat, si cela est nécessaire, en mettant sous vide le substrat muni du capot.

L'ensemble formé par la plaquette structurée, la colle et le capot de fermeture collective est alors découpé en puces individuelles.

Dans un mode de réalisation préféré de l'invention, des plots de sondes biologiques sont formés sur le capot avant assemblage, ce qui autorise l'utilisation d'un robot de « spotting » (par exemple du genre de ceux qui sont commercialisés par la Société Karl Suss) et donc la formation d'une matrice de sondes ponctuelles, qui sont éventuellement toutes différentes, afin d'effectuer simultanément, dans le même composant, une hybridation et une analyse multi-critères sur un même échantillon liquide.

Les zones formant des matrices de sondes biologiques sont disposées de façon à être, après assemblage, en regard de cavités (chambres) du substrat structuré.

Si nécessaire, des ouvertures sont percées dans le capot, comme on l'a vu, pour permettre l'injection d'échantillons liquides dans le circuit fluidique du composant formé.

Dans un exemple, le substrat structuré comprend des zones de rétrécissement (chicanes) dont la largeur vaut typiquement 20µm et qui permettent d'isoler deux chambres fluidiques voisines.

La formation de l'assemblage conformément à l'invention permet de ne pas détériorer les sondes biologiques déposées et de ne pas boucher ni recouvrir les zones de rétrécissement.

L'assemblage peut être réalisé collectivement sur l'ensemble des composants gravés sur un substrat de 100mm de diamètre, mais la technique de sérigraphie permet de travailler sur des substrats de dimensions très supérieures (diamètres supérieurs ou égaux à 200mm) car la taille des grilles n'est pas limitée.

Différents types de colles (en particulier des résines polymères), aptes à former des joints, peuvent être utilisés dans l'invention, par exemple :
- une colle époxy souple (par exemple du genre de celle qui est commercialement disponible sous la référence Duopox 1891),
- une colle cationique (par exemple du genre de celle qui est commercialement disponible sous la référence Delo Katiobond 45952),
- une colle silicone (par exemple du genre de celle qui est commercialement disponible sous la référence Toshiba GE TSE 399 ou TSE 397),
- une colle silicone (par exemple du genre de celle qui est commercialement disponible sous la référence Dow Corning DC866),
- un PDMS (par exemple du genre de celui qui est commercialement disponible sous la référence Dow Corning Sylgard 184).

Dans un autre mode de réalisation particulier de l'invention, le substrat structuré et le capot pourvu de sondes biologiques sont découpés en puces avant leur assemblage. L'enduction de colle est toujours effectuée suivant le même principe de sérigraphie mais se fait alors puce à puce. L'alignement et le placage sont effectués grâce à un équipement de type « pick-and-place » (bras-transfert), puis la colle est polymérisée, suivant la manière dont elle est mise en oeuvre, par insolation ultraviolette, chauffage ou séchage à l'air.

Dans un autre mode de réalisation particulier, le substrat micro-structuré est formé par une technique de réplication, injection ou matriçage à chaud, dans un polymère (PMMA, COC, Polycarbonate, TPX, PMMI, par exemple), ou encore par lithographie d'une résine photosensible épaisse (par exemple du genre de celle qui est commercialisée sous la référence EPON, SU8 ou MicroChem) sur un substrat qui est par exemple en silicium, en verre, en quartz, ou en silice. L'ensemble du procédé est alors le même.

## Revendications

1. Procédé d'encollage d'au moins un substrat micro-structuré (2, 32) comportant des zones planes supérieures coplanaires (6) et des creux (8) entre ces dernières, au moyen d'une colle (12) apte à adhérer à ces zones planes supérieures coplanaires, dans lequel :
- on met en place une grille (10) sans masque au dessus du substrat,
- on enduit cette grille de la colle, au moyen d'un outil (16) qui, par appui sur la grille, met localement cette grille en contact avec les zones planes supérieures coplanaires, de manière à déposer un film (20) de gouttelettes de colle sur ces zones planes supérieures coplanaires, et
- on retire la grille,
procédé dans lequel on effectue un traitement des zones planes supérieures coplanaires (6) avant d'y déposer le film de gouttelettes de colle, ce traitement étant prévu pour adapter la mouillabilité de ces zones à la colle.

2. Procédé selon la revendication 1, dans lequel l'outil est une racle (16).

3. Procédé selon l'une quelconque des revendications 1 et 2, dans lequel le traitement est prévu pour contrôler l'étalement des gouttelettes de colle sur les zones planes supérieures coplanaires (6).

4. Procédé selon l'une quelconque des revendications 1 à 3, dans lequel on ferme le substrat micro-structuré (32) par un substrat de fermeture (34) que l'on fixe aux zones planes supérieures coplanaires par l'intermédiaire de la colle déposée sur celles-ci.

5. Procédé selon la revendication 4, dans lequel les creux du substrat micro-structuré comportent des zones pourvues de sondes biologiques.

6. Procédé selon la revendication 4, dans lequel le substrat de fermeture (34) comporte des zones pourvues de sondes biologiques (40), ces zones étant aptes à se trouver en regard de creux du substrat micro-structuré après avoir fermé ce substrat micro-structuré.

7. Procédé selon l'une quelconque des revendications 4 à 6, dans lequel le substrat de fermeture (34) comporte des perçages (38) prévus pour l'introduction d'un fluide dans les creux du substrat micro-structuré.

8. Procédé selon l'une quelconque des revendications 4 à 7, dans lequel on fabrique au préalable, de façon collective, un ensemble de substrats micro-structurés sur un même substrat, les zones planes supérieures de l'ensemble des substrats micro-structurés étant coplanaires, on dépose un film de gouttelettes de colle sur l'ensemble de ces zones planes supérieures de façon collective, on ferme l'ensemble des substrats micro-structurés par un même substrat de fermeture et l'on sépare les uns des autres les substrats micro-structurés ainsi fermés.

9. Procédé selon l'une quelconque des revendications 4 à 7, dans lequel on fabrique au préalable, de façon collective, un ensemble de substrats micro-structurés sur un même substrat, les zones planes supérieures de l'ensemble des substrats micro-structurés étant coplanaires, et l'on fabrique aussi au préalable, de façon collective, un ensemble de substrats de fermeture sur un autre substrat, on sépare les uns et des autres les substrats micro-structurés et les substrats de fermeture et l'on ferme les substrats micro-structurés par les substrats de fermeture, après avoir déposé un film de gouttelettes de colle sur les zones planes supérieures coplanaires de chaque substrat micro-structuré.

10. Procédé selon l'une quelconque des revendications 4 à 7, dans lequel chaque substrat (2, 32, 34) est fait d'un matériau choisi parmi le verre, le silicium et les polymères.

## Claims

1. Process for gluing at least one micro-structured substrate (2, 32) comprising upper coplanar plane areas (6) and recesses (8) between them, by means of a glue (12) that can bond to these upper coplanar plane areas, wherein:
- a grid (10) with no mask is placed above the substrate,
- this grid is coated with the glue using a tool (16) which presses on the grid and locally brings this grid into contact with the upper coplanar plane areas, so as to deposit a film (20) of glue droplets on these upper coplanar plane areas, and
- the grid is removed,
process in which the upper coplanar plane areas (6) are treated before the film of glue droplets is deposited on it, this treatment being designed to adapt the wettability of these areas to the glue.

2. Process according to claim 1, in which the tool is a doctor blade (16).

3. Process according to one of claims 1 and 2, in which this treatment is designed to control spreading of glue droplets on the upper coplanar plane areas (6).

4. Process according to any one of claims 1 to 3, in which the micro-structured substrate (32) is closed with a closing substrate (34) that is fixed to the upper coplanar plane areas by the glue deposited on them.

5. Process according to claim 4, in which recesses in the micro-structured substrate comprise areas which are provided with biological probes.

6. Process according to claim 4, in which the closing substrate (34) comprises areas provided with biological probes (40), these areas being designed to be positioned facing the recesses in the micro-structured substrate after this micro-structured substrate has been closed.

7. Process according to any one of claims 4 to 6, in which the closing substrate (34) comprises drillings (38) through which a fluid will be added into the recesses in the micro-structured substrate.

8. Process according to any one of claims 4 to 7, in which a set of micro-structured substrates are collectively fabricated in advance on the same substrate, the upper plane areas of all the micro-structured substrates being coplanar, a film of glue droplets is deposited collectively on all of these upper plane areas, all of the micro-structured substrates are closed by the same closing substrate and the micro-structured substrates thus closed are separated from each other.

9. Process according to any one of claims 4 to 7, in which a set of micro-structured substrates are collectively fabricated in advance on the same substrate, the upper plane areas of all the micro-structured substrates being coplanar, and a set of closing substrates are fabricated collectively on another substrate, also in advance, the micro-structured substrates and the closing substrates are separated from each other and the micro-structured substrates are closed by the closing substrates after depositing a film of glue droplets on the upper coplanar plane areas of each micro-structured substrate.

10. Process according to any one of claims 4 to 7, in which each substrate (2, 32, 34) is made from a material chosen from among glass, silicon and polymers.

## Patentansprüche

1. Verfahren zum Verleimen mindestens eines mikrostrukturierten Substrats (2, 32), das coplanare erhabene ebene Bereiche (6) und Vertiefungen (8) zwischen diesen aufweist, mit Hilfe eines Klebstoffs (12), der dazu geeignet ist, an den coplanaren erhabenen ebenen Bereichen zu haften, wobei:
- ein Gitter (10) ohne Maske über dem Substrat angebracht wird,
- das Gitter mit Hilfe eines Werkzeugs (16), das durch Auflage auf dem Gitter das Gitter örtlich mit den coplanaren erhabenen ebenen Bereichen in Kontakt bringt, mit dem Klebstoff beschichtet wird, um einen Film (20) aus Klebstofftröpfehen auf den coplanaren erhabenen ebenen Bereichen abzuscheiden, und
- das Gitter entfernt wird,
wobei eine Behandlung der coplanaren erhabenen ebenen Bereiche (6) vorgenommen wird, bevor der Film aus Klebstofftröpfchen darauf abgeschieden wird, wobei die Behandlung dazu dient, die Benetzbarkeit der Bereiche an den Klebstoff anzupassen.

2. Verfahren nach Anspruch 1, wobei das Werkzeug eine Rakel (16) ist.

3. Verfahren nach einem der Ansprüche 1 und 2, wobei die Behandlung dazu dient, die Verteilung der Klebstofftröpfchen auf den coplanaren erhabenen ebenen Bereichen (6) zu steuern.

4. Verfahren nach einem der Ansprüche 1 bis 3, wobei das mikrostrukturierte Substrat (32) mit einem Verschlusssubstrat (34) verschlossen wird, welches auf den coplanaren erhabenen ebenen Bereichen mit Hilfe des darauf abgeschiedenen Klebstoffs befestigt wird.

5. Verfahren nach Anspruch 4, wobei die Vertiefungen des mikrostrukturierten Substrats mit biologischen Sonden versehene Bereiche umfassen.

6. Verfahren nach Anspruch 4, wobei das Verschlusssubstrat (34) mit biologischen Sonden (40) versehene Bereiche umfasst, wobei die Bereiche dazu geeignet sind, den Vertiefungen des mikrostrukturierten Substrats gegenüber zu liegen, nachdem das mikrostrukturierte Substrat verschlossen wurde.

7. Verfahren nach einem der Ansprüche 4 bis 6, wobei das Verschlusssubstrat (34) Bohrlöcher (38) aufweist, die für das Einbringen einer Flüssigkeit in die Vertiefungen des mikrostrukturierten Substrats bestimmt sind.

8. Verfahren nach einem der Ansprüche 4 bis 7, wobei vorab gesammelt eine Gesamtheit von mikrostrukturierten Substraten auf einem gleichen Substrat hergestellt wird, wobei die erhabenen ebenen Bereiche der Gesamtheit der mikrostrukturierten Substrate coplanar sind, ein Film aus Klebstofftröpfchen gesammelt auf der Gesamtheit der erhabenen ebenen Bereiche abgeschieden wird, die Gesamtheit der mikrostrukturierten Substrate mit einem gleichen Verschlusssubstrat verschlossen wird und die so verschlossenen mikrostrukturierten Substrate voneinander getrennt werden.

9. Verfahren nach einem der Ansprüche 4 bis 7, wobei vorab gesammelt eine Gesamtheit von mikrostrukturierten Substraten auf einem gleichen Substrat hergestellt wird, wobei die erhabenen ebenen Bereiche der Gesamtheit der mikrostrukturierten Substrate coplanar sind, und ebenfalls vorab gesammelt eine Gesamtheit von Verschlusssubstraten auf einem anderen Substrat hergestellt wird, die mikrostrukturierten Substrate und die Verschlusssubstrate voneinander getrennt werden und die mikrostrukturierten Substrate mit den Verschlusssubstraten verschlossen werden, nachdem ein Film aus Klebstofftröpfchen auf den coplanaren erhabenen ebenen Bereichen jedes mikrostrukturierten Substrats abgeschieden worden ist.

10. Verfahren nach einem der Ansprüche 4 bis 7, wobei jedes Substrat (2, 32, 34) aus einem Material, ausgewählt aus Glas, Silicium und Polymeren, besteht.
